# EUROPÄISCHE PATENTSCHRIFT

(11) **EP 0 786 639 B1**
(45) Veröffentlichungstag und Bekanntmachung des Hinweises auf die Patenterteilung: **05.09.2001**
(21) Anmeldenummer: 96119671.4
(22) Anmeldetag: 07.12.1996
(51) Int. Cl.: F28F 13/00, H05K 7/20

(54) **Wärmeleitfähiges Bauelement**
Heat conductive device
Dispositif conduisant la chaleur

(30) Priorität: 25.01.1996 DE 19602606
(43) Veröffentlichungstag der Anmeldung: 30.07.1997
(73) Patentinhaber: Astrium GmbH, 81663 München (DE)
(72) Erfinder: Hauser, Armin, Dipl.-Ing., 88690 Uhldingen (DE); Käppeler, Ernst, Dipl.-Ing., 88085 Langenargen (DE)
(74) Vertreter: Meel, Thomas

(56) Entgegenhaltungen:
- DE-A- 3 330 708
- US-A- 5 077 637
- US-A- 5 111 359
- US-A- 5 390 734

## Beschreibung

Die Erfindung betrifft ein Wärmeleitfähiges Bauelement aus:
- mindestens einem Strang matrixfreier gebündelter, im wesentlichen parallel zueinander verlaufender Kohlefasern oder Pechfasern und
- Schnittstellen zur Einkopplung und Auskopplung von Wärme, die senkrecht zu den Fasern verlaufen wobei
- im Bereich der Schnittstellen jeweils ein metallischer Aufnehmer mit einer Bohrung oder einer Nut für die Fasern vorhanden ist.

Ein derartiges Bauelement ist aus der US-A-5077637 (MARTORANA) bekannt, die nächstkommender Stand der Technik ist.

Aufgabe der Erfindung ist es, ein hoch wärmeleitfähiges Bauteil für den Wärmetransport von einer Wärmequelle zu einer Wärmesenke zu schaffen.

Diese Aufgabe wird erfindungsgemäss durch den Gegenstand des ersten Patentanspruchs gelöst, wobei die im abhängigen Anspruch offenbarte Weiterbildung der Erfindung darüberhinaus flexibel ist und die schwingungsfreie Übertragung von Wärme z.B. zwischen einem Sensor und einem mechanischen Kühler (Stirlingmaschine) ermöglicht.

Den Werkstofftabellen ist folgendes entnehmbar:

| Werkstoff | Wärmeleitfähigkeit | Dichte |
|---|---|---|
| Kupfer | 390 W/m K | 8.9 g/cm³ |
| Aluminium | 210 W/m K | 2.7 g/cm³ |
| Kohlefaser | 1000 W/m K | 2.2 g/cm³ |

Kohlefasern mit hohem E-Modul (Pechfasern) haben in Faserrichtung eine sehr hohe Wärmeleitfähigkeit; etwa 2 bis 3 mal höher als die von Kupfer. Darüberhinaus ist die Dichte von solchen Fasern etwa 4 mal geringer als die von Kupfer.

Durch mechanische Verdichtung matrixfreier Fasern kann der Faseranteil erhöht werden und damit die Wärmeleitfähigkeit pro Querschnitt im Vergleich zu üblichen Verbundwerkstoffen um mehr als 40 % verbessert werden. Die Wärme wird stirnseitig mit geringem thermischen Widerstand in die Fasern eingeleitet (senkrecht zur Faserrichtung ist die Wärmeleitfähigkeit sehr gering).

Die Erfindung wird nachfolgend anhand der Figuren näher erläutert.

Es zeigen:

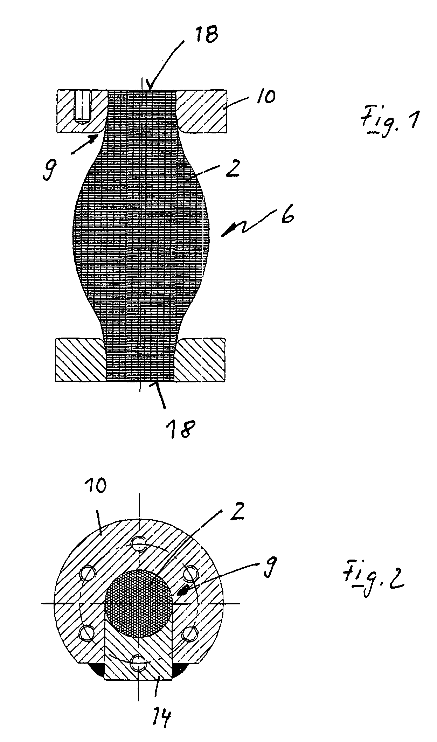

- Fig. 1 und 2: eine thermische Komponente in Seitenansicht und Draufsicht und
- Fig. 3 und 4: eine flexible thermische Komponente in Seitenansicht und Draufsicht.

Bei einer Ausführungsform der Erfindung werden aus Pechfasern oder Kohlefasern **2, 4** ohne Harz (Binder) zwischen den einzelnen Fasern ein Faserbündel **6** oder Faserstränge **8** gebildet. Das Kohlefaserbündel **6** (der Kohlefaserstrang **8**) ist kein Verbundwerkstoff, sondern zunächst ein loses Bündel oder ein loser Strang. Zum Beispiel mit Hilfe einer Wickelmaschine werden das Kohlefaserbündel **6** oder die Faserstränge **8** in die Bohrung **9** oder Nut **11** eines Aufnehmers **10, 12** eingebracht. Die geometrische Form der Bohrung oder Nut ist frei wählbar und wird dem Anwendungsfall angepasst. Anschliessend werden das Faserbündel **6** oder der Faserstrang **8** mittels eines Stempels **14, 16** unter Druck verdichtet. Der Stempel **14, 16** wird dann mit der Aufnahmeform mechanisch verbunden, z.B. kann er verschweißt werden. Die so entstandenen Bauteile werden an den senkrecht zu den Fasern verlaufenden Schnittstellen **18, 20** mit Wärmequellen oder Wärmesenken verbunden.

Mit verschiedenen Kohlefasertypen wurden Muster hergestellt. Es konnten Packungsdichten bis 85 % erreicht werden. Diese Packungsdichte liegt nahe dem für zylindrische Fasern theoretisch maximal möglichen Wert von 90,7 %.

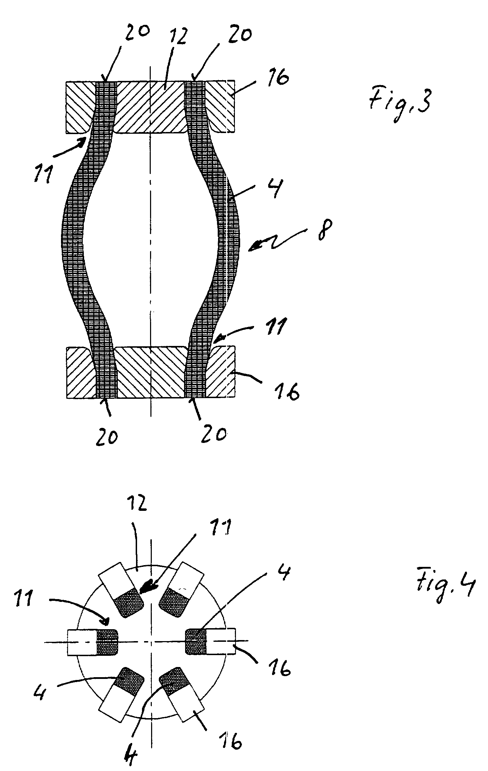

Mit dem Gegenstand der Erfindung können thermische Komponenten mit sehr hoher Wärmeleitfähigkeit bei geringem Gewicht herstellt werden und mit anderen Bauteilen auf einfache Weise verbunden werden. Wegen des geringen Faserdurchmessers (ca. 5-10 µm) sind auch flexible, thermisch gut leitende Komponenten möglich (Fig. 3 und 4). Hochverdichtete Pechfasern können z.B. auch in der Neutronenphysik eingesetzt werden.

### Abkürzungen, Maßeinheiten und Erläuterungen:

| | |
|---|---|
| Wärmeleitfähigkeit | Watt pro Meter und Kelvin |
| *µ*m micro meter | 10⁻⁶ m |

### Packungsdichte: Faseranteil pro Querschnitt

- Kohlefasern:: aus 90% - 100% Kohlenstoff bestehende Fasern, die z.B. aus Cellulose, Polyacrylnitridpolymeren (PAN) oder aus Pechen und Kohleextrakten hergestellt werden.
- Pechfasern:: Aus Pechen oder Kohleextrakten hergestellte Kohlefasern. Pechfasern haben in Faserrichtung eine sehr hohe Wärmeleitfähigkeit.

## Patentansprüche

1. Wärmeleitfähiges Bauelement aus:
- mindestens einem Strang (6,8) matrixfreier gebündelter, im wesentlichen parallel zueinander verlaufender Kohlefasern oder Pechfasern und
- Schnittstellen (18, 20) zur Einkopplung und Auskopplung von Wärme, die senkrecht zu den Fasern (2, 4) verlaufen wobei
- im Bereich der Schnittstellen jeweils ein metallischer Aufnehmer (10, 12) mit einer Bohrung (9) oder einer Nut (11) für die Fasern (2, 4) vorhanden ist,
**dadurch gekennzeichnet,** dass jeder Aufnehmer (10, 12) mit einem Stempel (14, 16) versehen ist, mittels dem die Fasern (2, 4) verdichtet werden, und wobei nach dem Verdichten eine mechanische Verbindung zwischen dem Stempel (14, 16) und dem Aufnehmer (10, 12) besteht.

2. Wärmeleitfähiges Bauelement nach Anspruch 1, **gekennzeichnet durch** mehrere Stränge (8) parallel verlaufender gebündelter Fasern (2, 4).

## Claims

1. Thermally conductive component comprising:
- at least one strand (6, 8) of matrix-free, bundled carbon fibres or pitch fibres which run substantially parallel to one another, and
- intersections (18, 20) for introducing and extracting heat, which run perpendicular to the fibres (2, 4), and
- in each case one metallic receiving means (10, 12) with a bore (9) or a groove (11) for the fibres (2, 4) being present in the region of the intersections,
**characterized in that** each receiving means (10, 12) is provided with a ram (14, 16), by means of which the fibres (2, 4) are compacted, and a mechanical connection existing between the ram (14, 16) and the receiving means (10, 12) after the compacting operation.

2. Thermally conductive component according to Claim 1, characterized by a plurality of strands (8) of parallel bundled fibres (2, 4).

## Revendications

1. Elément de construction conducteur de la chaleur, constitué
- d'au moins un brin (6, 8) de fibres de carbone ou de poix liées ensemble sans matrice, s'étendant de manière essentiellement parallèle les unes aux autres et
- d'interfaces (18, 20) pour le couplage à et le découplage de la chaleur, qui s'étendent perpendiculairement aux fibres (2, 4),
- une pièce réceptrice métallique (10, 12) étant à chaque fois présente au niveau des interfaces, présentant un orifice (9) ou une rainure (11) pour les fibres (2, 4),
**caractérisé en ce que** chaque pièce réceptrice (10, 12) a été pourvue d'un poinçon (14, 16) au moyen duquel les fibres (2, 4) sont comprimées, et dans lequel une liaison mécanique existe après la compression entre le poinçon (14, 16) et la pièce réceptrice (10, 12).

2. Elément de construction conducteur de la chaleur selon la revendication 1, caractérisé par plusieurs brins (8) de fibres (2, 4) liées ensemble s'étendant parallèlement.
